(19) Europäisches Patentamt
European Patent Office
Office européen des brevets

(11) **EP 3 996 234 A1**

(12) **EUROPEAN PATENT APPLICATION**
published in accordance with Art. 153(4) EPC

(43) Date of publication:
**11.05.2022 Bulletin 2022/19**

(21) Application number: **20834149.5**

(22) Date of filing: **29.06.2020**

(51) International Patent Classification (IPC):
**H02J 7/00** (2006.01)     **G01R 19/00** (2006.01)

(86) International application number:
**PCT/CN2020/098744**

(87) International publication number:
**WO 2021/000819 (07.01.2021 Gazette 2021/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.07.2019 CN 201910599532**

(71) Applicant: **Datang NXP Semiconductors Co., Ltd. County Town of Rudong County Jiangsu 226400 (CN)**

(72) Inventors:
• **VAN DONGEN, Marijn**
  **5656 AG Eindhoven (NL)**
• **VAN LAMMEREN, Joop**
  **5656 AG Eindhoven (NL)**
• **BUTHKER, Dick**
  **5656 AG Eindhoven (NL)**
• **BOEZEN, Henk**
  **5656 AG Eindhoven (NL)**
• **SCHOLTENS, Peter**
  **5656 AG Eindhoven (NL)**

(74) Representative: **EP&C**
  **P.O. Box 3241**
  **2280 GE Rijswijk (NL)**

(54) **BATTERY MANAGEMENT CIRCUIT AND BATTERY MODULE**

(57) The present invention relates to a battery management circuit, comprising a signal extraction unit, a clock capture unit, a voltage-controlled oscillator, and a voltage sampling unit. The signal extraction unit is suitable for extracting a synchronous pulse signal from a communication bus connected to the battery management circuit. The clock capture unit is connected to the signal extraction unit, and is suitable for generating a clock signal according to the synchronous pulse signal. The voltage-controlled oscillator is suitable for transforming a battery unit voltage into a voltage frequency signal. The voltage sampling unit is suitable for sampling the voltage frequency signal according to the clock signal to obtain a sampling voltage of the battery unit voltage.

Fig.1

**Description**

Technical Field

The present invention relates to a battery pack, in particular to a battery management circuit and a battery module of a battery pack.

Background

The Battery Management System (BMS) is the link between the battery and the user. It can improve the utilization rate of the battery, prevent the battery from being overcharged or over-discharged, and ensure the safety of the battery. It is widely used in electric vehicles, underwater robots and other fields..

The battery management system can measure various key parameters of the battery cell, such as the cell voltage. The reference voltage generated by the band gap reference circuit is usually used to measure the cell voltage. One of the challenges of accurate voltage measurement is to generate a sufficiently accurate and stable reference voltage. Not only the absolute accuracy of the reference voltage should be within the range of $100\mu V$, but also the guarantee of this accuracy during the lifetime and under mechanical stress conditions is needed. Due to the sensitivity of the PN junction to aging and stress, it is difficult to achieve such accuracy using a band gap reference.

One possible solution is to use a reference voltage based on a Zener diode. The disadvantage of this solution is that the Zener diode requires a power supply of approximately 6V, which is not available in a battery management system for a single battery cell. This battery management system is connected to a single battery cell with a minimum power supply on the order of 1.5V.

Summary

The technical problem to be solved by the present invention is to provide a battery management circuit and a battery module, which do not need to rely on a reference voltage and can achieve higher cell voltage measurement accuracy.

The technical solution adopted by the present invention to solve the above-mentioned technical problems is to propose a battery management circuit, which comprises a signal extraction unit, a clock capture unit, a voltage controlled oscillator, and a voltage sampling unit. The signal extraction unit is adapted to extract a synchronous pulse signal from a communication bus connected to the battery management circuit. The clock capture unit is connected to the signal extraction unit, and adapted to generate a clock signal according to the synchronous pulse signal. The voltage controlled oscillator is adapted to convert a battery cell voltage into a voltage-frequency signal. The voltage sampling unit is adapted to perform a sampling on the voltage-frequency signal according to the clock signal to obtain a sampling voltage of the battery cell voltage.

In an embodiment of the present invention, the battery management circuit further comprises a frequency divider, which is connected between the clock capture unit and the voltage sampling unit, and adapted to divide the frequency of the clock signal, wherein the voltage sampling unit uses a divided clock signal to perform the sampling.

In an embodiment of the present invention, the clock capture unit comprises a frequency-locked loop or a phase-locked loop.

In an embodiment of the present invention, the voltage sampling unit comprises a counter, wherein a data input terminal of the counter inputs the voltage frequency signal, and a reset terminal inputs the clock signal.

In an embodiment of the present invention, the battery management circuit further comprises a calibration unit, adapted to calibrate the sampling voltage according to a transfer function of the voltage controlled oscillator and the voltage sampling unit.

In an embodiment of the present invention, the battery management circuit further comprises an internal temperature sensor, which is adapted to detect an internal temperature of the battery management circuit, wherein the calibration unit is connected to the internal temperature sensor and is adapted to calibrate the sampling voltage using the internal temperature.

In an embodiment of the present invention, the voltage controlled oscillator comprises a ring oscillator, wherein the ring oscillator uses an adjustable voltage as a power supply, and the ring oscillator is adapted to output the voltage frequency signal.

In an embodiment of the present invention, the voltage controlled oscillator further comprises a bleeder circuit, a comparator and a transistor. The bleeder circuit is connected to the battery cell voltage, and is adapted to output a proportional voltage of the battery cell voltage; a positive input terminal of the comparator is connected to the adjustable voltage, and a negative input terminal is connected to the proportional voltage; a source of the transistor is connected to the battery cell voltage, a drain is connected to the adjustable voltage, and a gate is connected to a output terminal of the comparator.

The present invention also provides a battery module, which comprises a plurality of battery units, a plurality of battery management circuits as described above, and a module controller. Each battery management circuit is correspondingly connected to a pack of battery cells. The module controller is connected to at least part of the battery management circuit through a communication bus, wherein the module controller is configured to transmit a synchronous pulse signal based on a system clock.

In an embodiment of the present invention, the module controller is adapted to be connected to a crystal oscillator.

The present invention also provides a battery module, which comprises a plurality of packs of battery cells, a plurality of battery management circuits and a module controller. The battery management circuit is correspondingly connected to a pack of battery cells. The module controller is connected to at least part of the battery management circuit through a communication bus, and the module controller has a system clock. The battery management circuit is configured to lock an internal clock as the system clock.

Due to the adoption of the above technical solution, compared to the prior art, the present invention does not need to rely on the reference voltage to measure the voltage, but uses a very accurate crystal-based timing reference for voltage measurement, thereby improving the accuracy of the measurement.

Brief Description of the Drawings

In order to make the above-mentioned objects, features and advantages of the present invention more obvious and understandable, the specific implementations of the present invention will be described in detail below with reference to the accompanying drawings, in which:

Fig. 1 is a schematic diagram of a battery module according to an embodiment of the present invention.
Fig. 2 is a block diagram of a battery management circuit according to an embodiment of the present invention.
Fig. 3 is a waveform diagram of a low-level battery cell voltage of a battery management circuit of an embodiment of the present invention.
Fig. 4 is a waveform diagram of a high-level battery cell voltage of a battery management circuit of an embodiment of the present invention.
Fig. 5 is a circuit diagram of a voltage controlled oscillator according to an embodiment of the present invention.
Fig. 6 is a block diagram of a battery management circuit according to another embodiment of the present invention.

Preferred Embodiment of the Present Invention

In order to make the above objectives, features and advantages of the present invention more obvious and understandable, the specific embodiments of the present invention will be described in detail below with reference to the drawings.

In the following description, many specific details are set forth in order to fully understand the present invention, but the present invention can also be implemented in other ways different from those described herein, so the present invention is not limited by the specific embodiments disclosed below.

As shown in the present application and claims, unless the context clearly indicates exceptions, the words "a/an", "one", "a kind" and/or "the" do not specifically refer to the singular, but may also include the plural. Generally speaking, the terms "comprising" and "including" only suggest that the clearly identified steps and elements are included, and these steps and elements do not constitute an exclusive list, and the method or device may also include other steps or elements.

It should be understood that when a component is referred to as being "on another component", "connected to another component", "coupled to another component" or "contacting another component", it can be directly on, connected to, coupled to, or in contact with the other component, or an intervening component may be present. In contrast, when a component is referred to as being "directly on," "directly connected to," "directly coupled to," or "directly in contact with" another component, there is no intervening component. Likewise, when the first component is referred to as "electrical contact" or "electrically coupled to" the second component, there is an electrical path between the first component and the second component that allows current to flow. The electrical path may include capacitors, coupled inductors, and/or other components that allow current to flow, even without direct contact between conductive components.

An embodiment of the present invention describes a battery management circuit. In the context of the present invention, a battery management circuit may be used to manage one or more battery cells. Typically, a battery management circuit is implemented as a chip for managing a pack of battery cells. Many battery management circuits and optional additional devices constitute a battery management system.

In an embodiment of the present invention, a battery management circuit does not need to rely on the reference voltage and can achieve higher cell voltage measurement accuracy. In a battery module, a Microcontroller Unit (MCU) uses a very precise crystal-based timing reference to drive and communicate with all battery management circuits. By locking a system clock of each battery management circuit as the MCU clock, an accurate timing reference can be obtained in the battery management circuit, which can be used for voltage measurement.

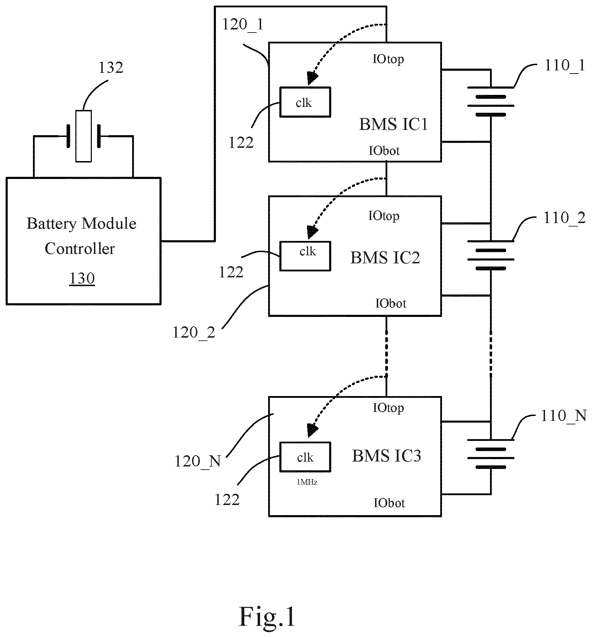

Fig. 1 is a schematic diagram of a battery module according to an embodiment of the present invention. As shown in Fig. 1, the battery module 100 may include multiple packs of batteries 110, such as 110_1, 110_2,... and 110_n, where n is a positive integer. Each battery pack 110 may include one or more battery cells, two of which are shown in the figure. The battery cells of each battery 110 may be connected in series or in parallel. The packs of batteries 110_1, 110_2, and 110_n may also be connected in series or in parallel. Fig. 1 shows an example in which battery cells and battery packs are connected in series. In Fig. 1, a plurality of battery management circuits 120 are provided, such as 120_1, 120_2, ... and 120_n. Each battery management circuit 120 can be connected in parallel to a corresponding pack of batteries 110 for monitoring and managing voltages of the corresponding pack of batteries. For example, the battery management circuit 120 can monitor the cell voltage of a pack of batteries 110. In some embodiments, each battery management circuit 120 is implemented as a semiconductor chip, but the present invention is not limited to this. Each battery management circuit 120 may be connected for communication. For example, each battery management circuit 120 may communicate through a communication bus. The form of the communication bus may be various known suitable communication buses. In one embodiment, a daisy-chain communication bus may be used. In Fig. 1, the interfaces IOtop and IObot between the battery management circuits 120 are illustrated.

These battery management circuits 120 may also be connected to the battery module controller 130 to exchange data. For example, the battery management circuit 120 can provide the measured battery voltage to the battery module controller 130. The battery module controller 130 can control the operation of the entire battery module including a plurality of packs of batteries 110. The battery module controller 130 is connected to the crystal 132. The internal oscillator (not shown in the figure) in the battery module controller 130 can use the crystal 132 to generate a very accurate system clock as a timing reference. The frequency of the system clock depends on the choice of technology, the speed required for processing/calculation, power consumption requirements and so on. In actual implementation, the frequency range of the system clock may be between tens of MHz and hundreds of MHz. The oscillator of the battery module controller 130 is used to drive a communication bus for controlling all the battery management circuits 120. After capturing the bus operating frequency of the battery module controller 130 through the communication bus, each battery management circuit 120 may lock its internal clock to the bus operating frequency, thereby achieving the same very high absolute accuracy.

Although Fig. 1 shows a battery management system based on a single-cell battery management circuit, the same principle may be applied to other types of systems, where crystal-based oscillator signals with high absolute accuracy may be used for locking.

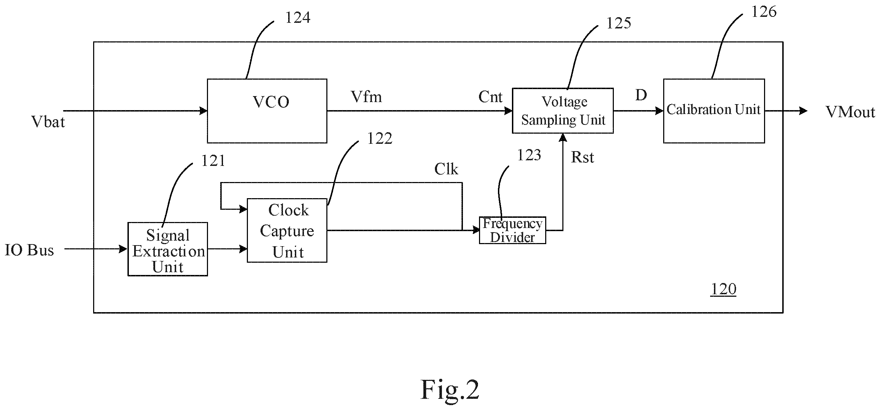

The precise clock in each battery management circuit 120 can be used to measure the battery voltage. Fig. 2 is a block diagram of a battery management circuit according to an embodiment of the present invention. As shown in Fig. 2, the battery management circuit 120 may include a signal extraction unit 121, a clock capture unit 122, a frequency divider 123, a voltage controlled oscillator (VCO) 124, a voltage sampling unit 125 and a calibration unit 126. The signal extraction unit 121 is adapted to be connected to the communication bus IO bus. There is a synchronous pulse signal containing a system clock from the battery module controller 130 on the communication bus. The signal extraction unit 121 extracts the synchronous pulse signal from the communication bus. The communication signal always uses a specific data rate or clock signal to run, and the purpose of the signal extraction unit 121 is to extract the timing information in this signal. The exact implementation of the signal extraction unit 121 largely depends on the modulation of the communication bus. For example, the communication signal can be Manchester coded, which means that the clock and data are combined in a single signal. The signal extraction unit 121 may extract the synchronous pulse signal based on the edge of the communication bus signal. These synchronous pulse signals form the input of the clock capture unit 122, so that a clock signal locked to the frequency of the communication bus can be generated.

The clock capture unit 122 is connected to the signal extraction unit 121, and is adapted to generate the clock signal Clk according to the synchronous pulse signal. The frequency of the clock signal Clk may be the same as the frequency of the system clock in the battery module controller 130. In embodiments of the present invention, the clock capture unit 122 may be implemented as a frequency locked loop (FLL) or a phase locked loop (PLL).

On the other hand, a voltage controlled oscillator (VCO) 124 is adapted to convert the battery cell voltage Vbat into a voltage frequency signal Vfm. Here, the battery cell voltage Vbat may be an analog value, and the voltage frequency signal may be a digital value including frequency information. This frequency information is related to the amplitude of the battery cell voltage Vbat. For example, the greater the amplitude, the greater the frequency.

The voltage sampling unit 125 may sample the voltage frequency signal Vfm according to the clock signal Clk to obtain the sampling voltage D of the battery cell voltage. Typically, the frequency of the clock signal Clk may be divided by the frequency divider 123 to obtain the frequency-divided signal Rst. The voltage sampling unit 125 uses the frequency-divided signal Rst for sampling. In one embodiment, the voltage sampling unit 125 may include a counter. The data input terminal of the counter inputs the voltage frequency signal Vfm, and the reset terminal inputs the clock signal Clk or its frequency division signal Rst. In the example of Fig. 2, an example using the frequency divider 123 is shown, but it is understood that the present invention covers an example in which the frequency divider 123 is not used. For description purpose, the following description uses the frequency divider 123 as an example. The counter can count the number of periods of the voltage frequency signal Vfm within the time window defined by the frequency division signal Rst, and the count value reflects the battery cell voltage Vbat. The Rst signal determines the integration time of the measurement. The longer the period of the Rst signal, the more periods of Vfm are counted, and the higher the resolution of the measurement is achieved. The frequency of the Rst signal depends on the application requirements and noise performance of the battery management circuit 120. The most likely minimum period of Rst is on the order of several ms, corresponding to a frequency of several hundred Hz.

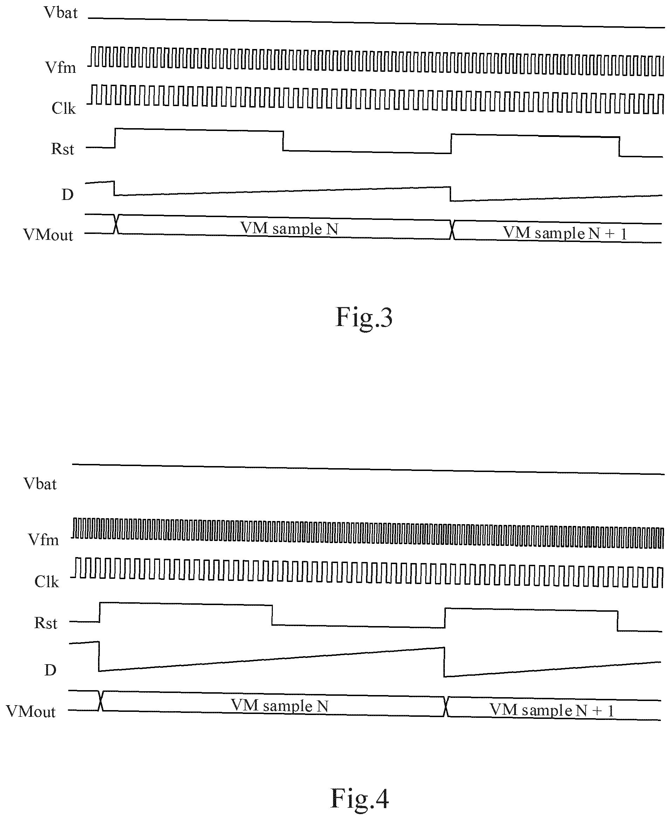

By counting the number of periods of Vfm during the time window set by the Rst signal, the output of the counter will represent the battery cell voltage. By making the counter period longer, the resolution of the output increases, at the expense of slower measurement speed. Fig. 3 is a waveform diagram of a low-level battery cell voltage of a battery management circuit of an embodiment of the present invention. Referring to Fig. 3, when the battery cell voltage Vbat is at a low level, the frequency of the converted voltage-frequency signal is also lower, and the pulses are less dense. The battery management circuit captures the clock signal Clk from the communication bus, and obtains the Rst signal through frequency division, which is used to sample the Vfm signal to obtain the sampling voltage D. D is a signal that gradually rises in one period of Rst. After being further calibrated, the measured voltage VMout is obtained. Fig. 4 is a waveform diagram of a high-level battery cell voltage of a battery management circuit of an embodiment of the present invention. Compared to Fig. 3, the battery cell voltage Vbat is at a high level, the frequency of the converted voltage-frequency signal is also higher, and the pulses are denser. Correspondingly, the amplitudes of the sampling voltage D and the measurement voltage VMout are also higher.

In the previous example, if the transfer function of the VCO 124 is f, then the voltage frequency Vfm = f(Vbat). The function f describes the relationship established by the VCO between the value of Vbat and the frequency of Vfm. Ideally, there will be a linear relationship, such as:

$$\text{freq}_{\text{Vfm}} = F\ (\text{Vbat}) = 100\text{MHz} + 10\text{MHz} \cdot \text{Vbat}$$

In this example, when Vbat = 5V, the frequency of VCO 124 will be 150MHz. This relationship needs to be used to convert the output of the voltage sampling unit 125 (which is a measure of the Vfm frequency) into an equivalent value Vbat.

The output of the voltage sampling unit 125 may need to be calibrated so that VMout= $f^{-1}$ (D ) = Vbat. Correspondingly, in this embodiment, the battery management circuit 120 may further include a calibration unit 126, which can calibrate the sampling voltage D according to the transfer function of the VCO 124.

Strictly speaking, the equation VMout = $f^{-1}$ (D) = Vbat mentioned above is not accurate enough. In one embodiment, it is better to also consider the transfer function of the voltage sampling unit 125 to convert D back to Vbat. However, the main purpose of the calibration unit 126 is to convert the value D back to the equivalent value of Vbat. In addition to other parameters, it will also use the transfer function f of the VCO 124, such as the frequency of the Rst signal.

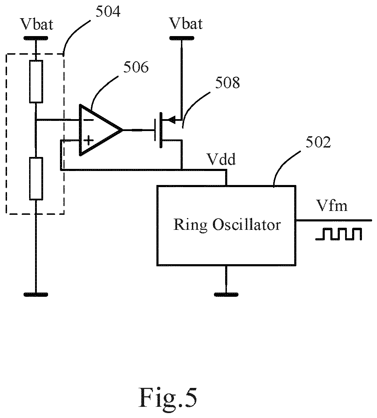

Fig. 5 is a circuit diagram of a voltage controlled oscillator according to an embodiment of the present invention. Referring to Fig. 5, the voltage controlled oscillator 124 may include a ring oscillator 502. The ring oscillator 502 uses an adjustable voltage Vdd as a power supply, and the ring oscillator 502 outputs the voltage frequency signal Vfm.

The adjustable voltage Vdd may be constructed in the following manner. The voltage controlled oscillator 124 further includes a bleeder circuit 504, a comparator 506 and a transistor 508. The bleeder circuit 504 may be connected to the battery cell voltage Vbat, and the bleeder circuit 504 is adapted to output a proportional voltage of the battery cell voltage Vbat. The positive input terminal of the comparator 506 is connected to the adjustable voltage Vdd, the negative input terminal is connected to the proportional voltage, and the output terminal of the comparator 506 outputs the result of the comparison between these two. The source of the transistor 508 is connected to the battery cell voltage Vbat, the drain is connected to the adjustable voltage Vdd, and the gate is connected to the output terminal of the comparator.

There is a significant relationship between the output frequency of the ring oscillator 502 and its power supply voltage. Therefore, the output frequency may be adjusted by the power supply voltage Vdd.

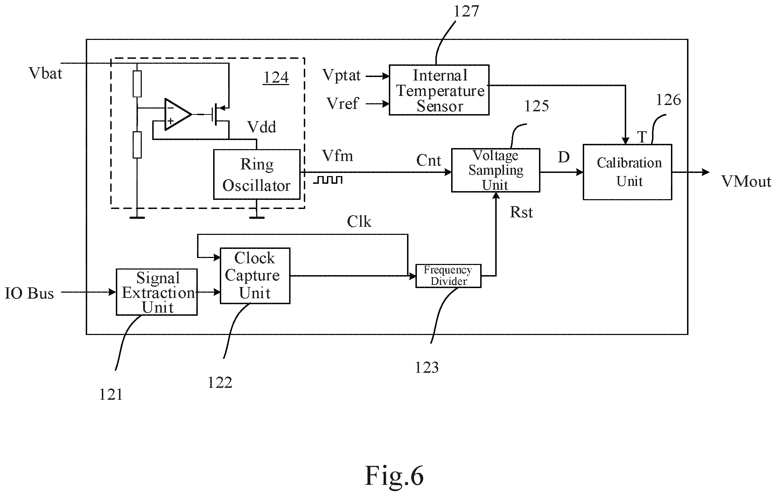

There is also a significant relationship between the output frequency of the ring oscillator 502 and the temperature, so the reference temperature is needed for calibration. Fig. 6 is a block diagram of a battery management circuit according to another embodiment of the present invention. As shown in Fig. 6, the battery management circuit 120 further includes an internal temperature sensor 127, which is adapted to detect the internal temperature of the battery management circuit. The calibration unit 126 is connected to the internal temperature sensor 127, and is adapted to use the internal temperature detected by the internal temperature sensor 127 to calibrate the sampling voltage. The output of the internal temperature sensor 127 may be used to compensate the temperature sensitivity of the VCO 124 through calibration. In this way, the output frequency of the ring oscillator 502 (measured using an accurate reference frequency) may be mapped back to the equivalent input voltage Vbat.

In the above-mentioned embodiment of the present invention, the ring oscillator is selected only for purpose of simplification. In other embodiments, other oscillator whose output frequency depends on the supply voltage may be used. Another possible implementation of a voltage-controlled oscillator that may be considered is a voltage average feedback relaxation oscillator (VAF), which is designed to achieve an output frequency that is independent of power supply and temperature. This implementation also does not require a voltage reference.

The type of analog-to-digital converter (ADC) described in the present invention is called "intermediate FM-level ADC" or "voltage-to-frequency converter" in the art. A feature of the present invention is that this type of ADC is applied to the battery management circuit, benefiting from the crystal-based frequency reference provided by the MCU, and the frequency reference is distributed among all battery management circuits.

Although the present invention has been described with reference to the current specific embodiments, those of ordinary skills in the art should recognize that the above embodiments are only used to illustrate the present invention, and various equivalent changes or substitutions can be made without departing from the spirit of the present invention. Therefore, as long as the changes and modifications of the above-mentioned embodiments are within the essential spirit of the present invention, they will fall within the scope of the claims of the present application.

**Claims**

1. A battery management circuit, comprising:

   a signal extraction unit, adapted to extract a synchronous pulse signal from a communication bus connected to the battery management circuit;
   a clock capture unit, connected to the signal extraction unit, and adapted to generate a clock signal according to the synchronous pulse signal;
   a voltage controlled oscillator, adapted to convert a battery cell voltage into a voltage-frequency signal; and
   a voltage sampling unit, adapted to perform a sampling on the voltage-frequency signal according to the clock signal to obtain a sampling voltage of the battery cell voltage.

2. The battery management circuit according to claim 1, further comprising a frequency divider, connected between the clock capture unit and the voltage sampling unit, and adapted to divide a frequency of the clock signal, wherein the voltage sampling unit uses a divided clock signal to perform the sampling.

3. The battery management circuit according to claim 1, wherein the clock capture unit comprises a frequency-locked loop or a phase-locked loop.

4. The battery management circuit according to claim 1, wherein the voltage sampling unit comprises a counter, wherein a data input terminal of the counter inputs the voltage frequency signal, and a reset terminal inputs the clock signal.

5. The battery management circuit according to claim 1, further comprising a calibration unit, adapted to calibrate the sampling voltage according to a transfer function of the voltage controlled oscillator and/or the voltage sampling unit.

6. The battery management circuit according to claim 5, further comprising an internal temperature sensor, which is adapted to detect an internal temperature of the battery management circuit, wherein the calibration unit is connected to the internal temperature sensor and is adapted to calibrate the sampling voltage using the internal temperature.

7. The battery management circuit according to claim 1, wherein the voltage controlled oscillator comprises:

   a ring oscillator, wherein the ring oscillator uses an adjustable voltage as a power supply, and
   the ring oscillator is adapted to output the voltage frequency signal.

8. The battery management circuit according to claim 7, wherein the voltage controlled oscillator further comprises:

   a bleeder circuit, connected to the battery cell voltage, wherein the bleeder circuit is adapted to output a proportional voltage of the battery cell voltage;
   a comparator, wherein a positive input terminal of the comparator is connected to the adjustable voltage, and a negative input terminal is connected to the proportional voltage; and

a transistor, wherein a source of the transistor is connected to the battery cell voltage, a drain is connected to the adjustable voltage, and a gate is connected to an output terminal of the comparator.

9. A battery module, comprising:

a plurality of packs of battery cells;
a plurality of battery management circuits according to any one of claims 1-8, wherein each battery management circuit is correspondingly connected to a pack of battery cells; and
a module controller, connected to at least a part of the plurality of battery management circuits through a communication bus, wherein the module controller is configured to transmit a synchronous pulse signal based on a system clock.

10. The battery module according to claim 9, wherein the module controller has an oscillator, and the oscillator is adapted to be connected to an external crystal.

11. A battery module, comprising:

a plurality of packs of battery cells;
a plurality of battery management circuits, wherein each battery management circuit is correspondingly connected to a pack of battery cells; and
a module controller, connected to at least a part of the plurality of battery management circuits through a communication bus, wherein the module controller has a system clock;
wherein the battery management circuit is configured to lock an internal clock as the system clock.

Fig.1

Fig.2

Vbat

Vfm

Clk

Rst

D

VMout | VM sample N | VM sample N + 1

Fig.3

Vbat

Vfm

Clk

Rst

D

VMout | VM sample N | VM sample N + 1

Fig.4

504

Vbat    Vbat

506

508

502

Vdd

Ring Oscillator    Vfm

Fig.5

Fig.6

| INTERNATIONAL SEARCH REPORT | International application No. |
|---|---|
| | **PCT/CN2020/098744** |

**A.    CLASSIFICATION OF SUBJECT MATTER**

H02J 7/00(2006.01)i;  G01R 19/00(2006.01)i

According to International Patent Classification (IPC) or to both national classification and IPC

**B.    FIELDS SEARCHED**

Minimum documentation searched (classification system followed by classification symbols)

H02J; G01R

Documentation searched other than minimum documentation to the extent that such documents are included in the fields searched

Electronic data base consulted during the international search (name of data base and, where practicable, search terms used)

CNABS; CNTXT; CNKI; IEEE; VEN; USTXT; WOTXT; EPTXT: 电压, 测量, 检测, 采样, 分频, 压控振荡器, 时钟, voltage, detec+, sampl+, frequency divid+, vco, oscillator, clock

**C.    DOCUMENTS CONSIDERED TO BE RELEVANT**

| Category* | Citation of document, with indication, where appropriate, of the relevant passages | Relevant to claim No. |
|---|---|---|
| PX | CN 110289656 A (DATANG NXP SEMICONDUCTORS CO., LTD.) 27 September 2019 (2019-09-27)<br>claims 1-11 | 1-11 |
| Y | CN 208874316 U (ZHOU, Xiwei) 17 May 2019 (2019-05-17)<br>description paragraphs [0022]-[0043], figures 1, 2 | 11, |
| Y | CN 104136928 A (QUALCOMM INC.) 05 November 2014 (2014-11-05)<br>description, paragraphs [0049]-[0113], and figures 1-14 | 11, |
| A | CN 104136928 A (QUALCOMM INC.) 05 November 2014 (2014-11-05)<br>description, paragraphs [0049]-[0113], and figures 1-14 | 1-10 |
| A | CN 204832336 U (DALIAN LVSHUN POWER AND ELECTRONIC EQUIPMENT CO.,LTD.) 02 December 2015 (2015-12-02)<br>entire document | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 August 2020** | **27 September 2020** |

| Name and mailing address of the ISA/CN | Authorized officer |
|---|---|
| **China National Intellectual Property Administration (ISA/ CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/098744**

| Patent document cited in search report | | | Publication date (day/month/year) | Patent family member(s) | | | Publication date (day/month/year) |
|---|---|---|---|---|---|---|---|
| CN | 110289656 | A | 27 September 2019 | None | | | |
| CN | 208874316 | U | 17 May 2019 | CN | 111009929 | A | 14 April 2020 |
| CN | 104136928 | A | 05 November 2014 | KR | 101561520 | B1 | 19 October 2015 |
| | | | | JP | 5823638 | B2 | 25 November 2015 |
| | | | | US | 8669794 | B2 | 11 March 2014 |
| | | | | US | 2013214831 | A1 | 22 August 2013 |
| | | | | EP | 2817643 | A1 | 31 December 2014 |
| | | | | WO | 2013126611 | A1 | 29 August 2013 |
| | | | | KR | 20140129213 | A | 06 November 2014 |
| | | | | JP | 2015514967 | A | 21 May 2015 |
| | | | | EP | 2817643 | B1 | 19 December 2018 |
| | | | | CN | 104136928 | B | 04 May 2016 |
| | | | | IN | 324290 | B | 08 November 2019 |
| | | | | IN | 201405503 | P4 | 04 March 2016 |
| CN | 204832336 | U | 02 December 2015 | None | | | |

Form PCT/ISA/210 (patent family annex) (January 2015)